# EUROPEAN PATENT SPECIFICATION

(11) **EP 3 373 337 B1**
(45) Date of publication and mention of the grant of the patent: **03.03.2021**
(21) Application number: 16843280.5
(22) Date of filing: 05.09.2016
(51) Int. Cl.: H01L 29/786, H01L 29/78, H01L 21/02, H01L 21/336, H01L 51/40

(54) **METHOD FOR PRODUCING A CARBON NANOTUBE SEMICONDUCTOR DEVICE**
VERFAHREN ZUR HERSTELLUNG EINES KOHLENSTOFFNANORÖHRCHENHALBLEITERBAUELEMENTS
PROCÉDÉ DE PRÉPARATION DE DISPOSITIF À SEMI-CONDUCTEURS À NANOTUBES DE CARBONE

(30) Priority: 02.11.2015 CN 201510729479
(43) Date of publication of application: 12.09.2018
(73) Proprietor: BOE Technology Group Co., Ltd., Beijing 100015 (CN); Peking University, Beijing 100871 (CN)
(72) Inventor: LIANG, Xuelei, Beijing 100176 (CN); HUI, Guanbao, Beijing 100176 (CN); XIA, Jiye, Beijing 100176 (CN); ZHANG, Fangzhen, Beijing 100176 (CN); ZHAO, Haiyan, Beijing 100176 (CN); TIAN, Boyuan, Beijing 100176 (CN); YAN, Qiuping, Beijing 100176 (CN); PENG, Lianmao, Beijing 100176 (CN)
(74) Representative: Gesthuysen Patentanwälte
(86) International application number: PCT/CN2016/098035
(87) International publication number: WO 2017/076121

(56) References cited:
- CN-A- 101 520 430
- CN-A- 101 540 285
- CN-A- 102 664 269
- CN-A- 105 336 792
- US-A1- 2009 140 237
- US-A1- 2015 202 662
- US-B2- 7 091 096

## Description

### FIELD

The present disclosure pertains to the field of carbon nanotube (CNT) technologies, and relates to the manufacture of a CNT semiconductor device. Specifically, the present disclosure relates to a manufacturing method of a CNT semiconductor device in which CNT layers are treated with an acidic solution.

### BACKGROUND ART

CNT thin films have been the focus of nanotechnologies in recent years, wherein carbon nanotubes (CNT) having semiconductor properties can be applied in various semiconductor devices such as diodes, field effect transistors (FET) and so on. As an example, in a carbon nanotube field effect transistor (CNT-FET), carbon nanotubes form conductive channels having semiconductor properties. Thereby, CNT layers can be used for manufacturing the simplest and most fundamental electronic device, i.e., a MOSFET. Moreover, CNT thin films can also be further used for manufacturing a thin film transistor (TFT) formed on the basis of CNT. The channel layer of a carbon nanotube thin film transistor (CNT-TFT) is a CNT thin film layer, and CNT-TFT may be applied as a drive transistor in a display.

Although CNT thin films are characterized by merits such as flexibility, transparency, high mobility, low cost and large scale, CNT-FETs or CNT-TFTs formed on the basis of CNT thin films still have problems in terms of performance uniformity. For example, multiple CNT-TFTs manufactured under a same process condition may have quite different transfer characteristics. In other words, the performances of CNT-FETs or CNT-TFTs manufactured in mass quantities using the existing method are not uniform. The lack of uniformity also greatly restricts the large scale application of CNT-FETs or CNT-TFTs in an industrial field.

Similar problems also exist in other CNT semiconductor devices formed on the basis of CNT layers.

The US2015202662 (A1) discloses a process for the cleaning of carbon nanostructure and similar materials and structures for removal of surfactant chemicals. The process includes washing the carbon nanostructures with concentrated acetic acid which may be glacial acetic acid. The cleaning process is also considered in carbon nanostructure film preparation with deposition of carbon nanostructures in solution with surfactant chemicals before the washing. Possible surfactants include sodium cholate (SC) and sodium dodecyl sulfate (SDS). Carbon nanostructure deposition on a substrate may be by various printing methods.

The US2009140237(A1) discloses a thin film transistor has a semiconducting layer comprising a semiconductor and a mixture enriched in metallic carbon nanotubes. The semiconducting layer has improved charge carrier mobility.

### SUMMARY

The present disclosure aims to improve the performance uniformity of a CNT semiconductor device.

To achieve the above goal or other goals, the present disclosure provides technical solutions as follows.

According to a first aspect of the present disclosure, a manufacturing method of a CNT semiconductor device is provided. The method comprises: forming a CNT layer with a CNT solution; and treating the CNT layer with an acidic solution. The semiconductor device is a carbon nanotube field effect transistor or a carbon nanotube thin film transistor, and the carbon nanotube layer is at least partially used for forming a semiconductor layer between a source and a drain of the carbon nanotube field effect transistor or the carbon nanotube thin film transistor. The manufacturing method further comprises forming the source and the drain through a patterning process, before treating the carbon nanotube layer with an acidic solution. The step of forming the source and the drain through a patterning process comprises: depositing a metal thin film layer; forming a photoresist layer over the metal thin film layer through a patterning process, to cover the region in which the source and the drain are to be formed, and performing etching by using the photoresist layer as a mask, until the carbon nanotube layer is exposed, with the photoresist layer being retained. The manufacturing method further comprises removing the photoresist layer after treatment of the carbon nanotube layer with the acidic solution.

Optionally, the manufacturing method according to an embodiment of the present disclosure further comprises: prior to forming a CNT layer with a CNT solution, performing decentralized processing on the CNT solution with an organic solvent.

Optionally, the organic solvent can be toluene, xylene, chloroform or o-xylene.

In a further embodiment, optionally, the source and the drain are made of a metal material resistant to corrosion of acidic solutions.

In the manufacturing method according to a further embodiment, the CNT layer is treated with an acidic solution for 1 to 2 minutes.

In the manufacturing method according to a further embodiment, carbon nanotubes in the CNT layer are single-wall carbon nanotubes, dual-wall carbon nanotubes, multi-wall carbon nanotubes, or a combination thereof. Alternatively, carbon nanotubes in the CNT layer are carbon nanotube bundles.

In the manufacturing method according to a further embodiment, the acidic solution is a mixed solution of phosphoric acid, nitric acid, and acetic acid.

In the manufacturing method according to a further embodiment, the phosphoric acid, the nitric acid, and the acetic acid in the mixed solution are respectively 75%∼85%, 3%∼7% and 3%∼7% by mass.

According to the CNT semiconductor device and the manufacturing method thereof provided in the embodiments of the present disclosure, chemical impurities in a CNT layer can be effectively removed by treatment with an acidic solution, which greatly improves the performance uniformity of a CNT-TFT semiconductor device.

### BRIEF DESCRIPTION OF DRAWINGS

The above and other goals and advantages of the present disclosure will be rendered clearer and more complete in combination with detailed explanations of the drawings below. In the drawings, same or similar elements are indicated by same reference signs.
Fig. 1 is a schematic flow diagram of a method for manufacturing a CNT-TFT according to an embodiment of the present disclosure;
Fig. 2 is a schematic flow diagram of a method for manufacturing a CNT-TFT according to a reference embodiment not forming part of the present disclosure;
Fig. 3 is a schematic view for a basic structure of a CNT-TFT manufactured according to the method for manufacturing a CNT-TFT provided in the present disclosure; and
Fig. 4 is a schematic comparison view for transfer characteristics of CNT-TFTs obtained without treatment by an acidic solution and with treatment by an acidic solution respectively.

### DETAILED DESCRIPTION OF EMBODIMENTS

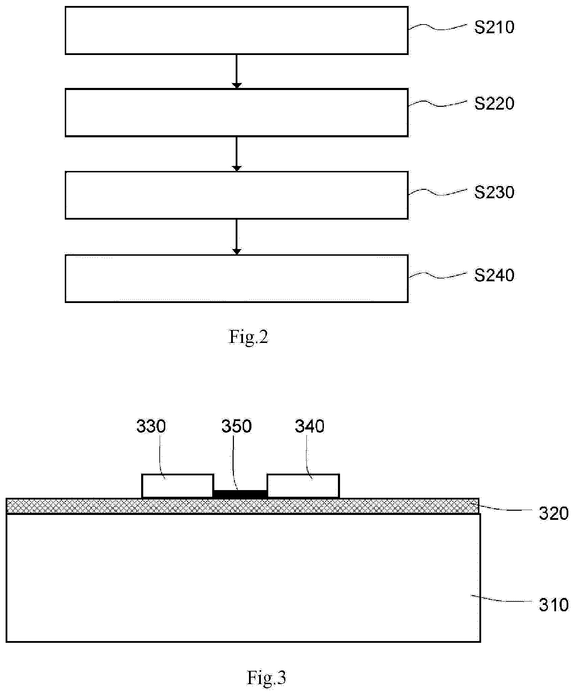

Fig. 3 is a schematic view for a basic structure of a CNT-TFT manufactured according to the method for manufacturing a CNT-TFT provided in the present disclosure. In Fig. 3, various thicknesses of layers and regions are exaggerated for clarity. Moreover, proportional relationships between dimensions of each component in Fig. 3 are only intended to be schematic, rather than reflecting the true proportional relationships between the dimensions of each component. The CNT-TFT shown in Fig. 3 can be manufactured according to an embodiment of a manufacturing method disclosed below.

It should be noted that the semiconductor device in an embodiment of the present disclosure is a carbon nanotube field effect transistor (CNT-FET) or a carbon nanotube thin film transistor (CNT-TFT). Besides, the CNT layer is at least partially used for forming a semiconductor layer between a source and a drain of the CNT-FET or the CNT-TFT. The embodiment of Fig. 3 is illustrated with the semiconductor device being a CNT-TFT as an example, but it is not limited thereto.

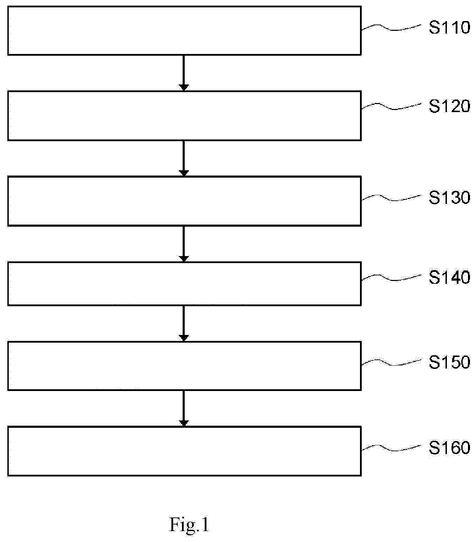

Fig. 1 is a schematic flow diagram of a method for manufacturing a CNT-TFT according to an embodiment of the present disclosure. The manufacturing method of a CNT-TFT in an embodiment of the present disclosure will be explained in detail as follows with reference to Fig. 1 and Fig. 3.

Firstly, in step S110, a substrate which has been cleaned is provided.

In this step, the provided substrate can be but not limited to silicon wafer, and it corresponds to a silicon substrate 310 shown in Fig. 3 and a gate dielectric layer 320 formed thereon. The gate dielectric layer 320 can specifically be silicon dioxide, which is formed by thermal oxidation of the silicon substrate, or by other methods such as film deposition.

Furthermore, in step S120, a CNT thin film layer is formed on the substrate with a CNT solution.

In this step, the CNT thin film layer can be obtained on the basis of a CNT solution by a soaking method. Specifically, the substrate can be soaked into the CNT solution. After a period of time, the substrate is taken out, then washed and dried. Obviously, the CNT thin film layer can be formed on the basis of a CNT solution by solution spraying, chemical assembling (for example, LB thin film method) and so on. A method for forming a CNT thin film layer on the basis of a CNT solution can be called "a solution process", the specific implementation of which is not limited to those specific embodiments of the present disclosure. Besides, the thickness of the formed CNT thin film layer can be determined according to various structural parameters of the CNT-TFT to be formed.

Specifically, in other preferred embodiments, prior to formation of a CNT layer, decentralized processing is performed on the CNT solution with an organic solvent so as to obtain a CNT solution which is comparatively uniform and stable. The specific organic solvent in use can be but not limited to toluene, xylene, chloroform or o-xylene. It should be understood that the procedure of dispersing carbon nanotubes to form a solution is complicated in itself. It is usually necessary to use a surfactant and other chemical substances such that powdered carbon nanotubes can be easily dissolved in the solvent, thereby obtaining a stable CNT solution. It should also be understood that since the CNT powder for forming a CNT solution may contain both a metal type CNT and a semiconductor type CNT, a chemical agent (for instance a surfactant) may be needed to remove the metal type CNT, thereby obtaining a stable semiconductor type CNT solution with a comparatively high purity. As an example, the CNT solution used in the above embodiments is a semiconductor type CNT solution with the metal type CNT being removed.

The CNT thin film layer formed by the above steps comprises a semiconductor type CNT, and can be used to form a semiconductor layer between a source and a drain of the CNT-TFT, i.e., a channel layer between the source and the drain. CNTs in the CNT thin film layer can be single-wall carbon nanotubes, dual-wall carbon nanotubes, multi-wall carbon nanotubes, or a combination thereof. Alternatively, CNTs in the CNT layer are carbon nanotube bundles.

It should be noted that, optionally, a patterning process can be performed upon actual needs on the CNT thin film layer formed through the above steps. For example, the CNT thin film layer is patterned by etching to form a semiconductor layer between the source and the drain, and specific patterns for the patterning are not limited.

Furthermore, in step S130, a source and a drain are formed on the substrate through a patterning process.

In this step, photolithography can be adopted. A source 330 and a drain 340 shown in Fig. 3 are formed by photolithographic patterning. The source 330 and the drain 340 can be formed by a metal thin film layer, and they are connected via the CNT thin film layer.

It should be noted that the step of forming the source and the drain through a patterning process is carried out before treatment of the CNT layer with an acidic solution.

Furthermore, the formation of the source and the drain through a patterning process is implemented as follows.

The first option: not forming part of the present invention a region other than the one in which the source and the drain are to be formed is covered by a photoresist layer. Specifically, the region in which the source and the drain are to be formed is not covered by the photoresist layer (i.e., the semiconductor layer between the source and the drain is exposed). Then a metal thin film layer is deposited, and furthermore the photoresist layer is removed. In this case, the metal thin film layer on the photoresist layer is removed at the same time. In this way, the metal thin film layer in the region in which the source and the drain are to be formed is retained, thereby forming the source and the drain.

The second option which represents the present invention: a metal thin film layer is deposited first, and then a photoresist layer is formed on the metal thin film layer to cover the region in which the source and the drain are to be formed. Furthermore, etching is performed by using the photoresist layer as a mask, until the CNT thin film layer is exposed. Finally, the photoresist layer over the source and the drain is removed.

Based on the first option not forming part of the present invention, no etching is needed, and the CNT thin film layer, except for the region in which the source and the drain are to be formed, is covered by the photoresist layer, particularly in a region for forming channels. Therefore, the CNT thin film layer can be well protected.

Furthermore, in step S140, a protective layer is formed on the source and the drain by photolithographic patterning.

In this step, a region other than the channel region is covered by a photoresist, so at least the source and the drain are covered. The photoresist mask is used as a protective layer for the source and the drain. The protective layer does not cover the CNT thin film layer for forming channels, such that the CNT thin film layer is exposed and ready for treatment with an acidic solution in the following steps. The protective layer can specifically be but not limited to photoresist S1813 or electron beam resist PMMA and the like. The protective layer can basically protect the source and the drain against the influence of treatment with an acidic solution in the following step S150.

In the present invention the source and the drain are formed through the second option of the above step S130, the photoresist layer over the source and the drain can be retained rather than be removed. In this step, the photoresist layer is used as a protective layer, and thereby the step S140 can be omitted.

Furthermore, in step S150, at least the CNT thin film layer for forming the channels is soaked into an acidic solution, then taken out and washed with water.

It is found that when a CNT thin film layer is formed based on a CNT solution, some unnecessary impurities, for example polymeric impurities, may be contained in the solution or on a surface of CNT in the solution. Such impurities will be deposited on the substrate in the manufacture of a CNT thin film layer during the above step S120, or even attached to an outer wall surface of part of the carbon nanotubes. When a semiconductor device or a CNT-TFT is manufactured on the basis of such a CNT thin film layer containing impurities, presence of the impurities will lead to more charge traps on an interface between the CNT thin film layer and the dielectric layer in contact with an upper surface and/or a lower surface thereof, thereby influencing the performance uniformity of the CNT-TFT to be manufactured.

In this step, the CNT thin film layer is soaked into the acidic solution for treatment. Now, the above impurities can be removed by the acidic solution, and thereby a CNT thin film layer which is comparatively clean and uniform can be obtained. That is to say, a CNT thin film layer 350 shown in Fig. 3 for forming the channels. Such a CNT thin film layer 350 has correspondingly less charge traps, and hence obtains better performance uniformity. In this step, the source 330 and the drain 340 are protected by the protective layer against the acidic solution.

Specifically, the acidic solution can be a mixed solution of phosphoric acid, nitric acid, and acetic acid. The phosphoric acid, the nitric acid, and the acetic acid in the mixed solution are respectively 75%∼85%, 3%∼7% and 3%∼7% by mass, for example, 80%, 5% and 5% respectively, or 79%, 4% and 4% respectively. The CNT thin film layer can be soaked into the acidic solution for 1 to 2 minutes at a room temperature, then taken out, and washed with water to remove residuals of the acidic solution. Furthermore, in step S160, the protective layer on the source and the drain is removed. Specifically, the substrate can be soaked in a PG removal solution to remove the protective layer of the photoresist material, and then washed with water.

So far, the manufacturing method of a CNT-TFT shown in the embodiment of Fig. 3 is accomplished. It should be understood that a plurality of CNT-TFTs exemplified in Fig. 3 can be manufactured in mass quantities on the same substrate according to the above manufacturing method.

It should be noted that, in another alternative reference embodiment not forming part of the present invention, if the source 330 and the drain 340 are manufactured by some metal materials (such as Pt and Au) which are resistant to corrosion of the acidic solution used in the subsequent step S150, the electrodes can be directly put into the acidic solution for treatment without the step of forming a protective layer thereon. Thereby, step S140 is omitted, and obviously step S160 can also be omitted.

Fig. 2 is a schematic flow diagram of a method for manufacturing a CNT-TFT according to a further reference embodiment not forming part of the present disclosure. The manufacturing method of a CNT-TFT in this reference embodiment will be explained in detail with reference to Fig. 2 and Fig. 3.

Specifically, in step S210, a substrate which has been cleaned is provided. For the implementation of this step, the procedure described in the above step S110 can be referred to.

Furthermore, in step S220, a CNT thin film layer is formed on the substrate with a CNT solution. For the implementation of this step, the procedure described in the above step S120 can be specifically referred to. Furthermore, in step S230, at least the CNT thin film layer for forming channels is soaked into an acidic solution, then taken out, and washed with water. For the implementation of this step, the procedure described in the above step S150 can be specifically referred to. Besides, in this embodiment, since the source 330 and the drain 340 have not been formed when performing treatment with the acidic solution, it is unnecessary to form the protective layer as shown in step S140 in the embodiment of Fig. 1. Based on this, the process procedure is simplified. Furthermore, in step S240, a source and a drain are formed through a patterning process on the substrate. For the implementation of this step, the procedure described in the above step S130 can be referred to.

So far, the CNT-TFT shown in the embodiment of Fig. 3 can also be manufactured.

It should be noted that, compared with a CNT thin film layer of a traditional CNT-TFT, chemical impurities are greatly decreased in a CNT thin film layer 350 for forming channels according to an embodiment of the present disclosure, and the performance uniformity of the CNT-TFT device is thus improved. This is because chemical impurities influencing the performance uniformity of the CNT-TFT device are removed through treatment with an acidic solution.

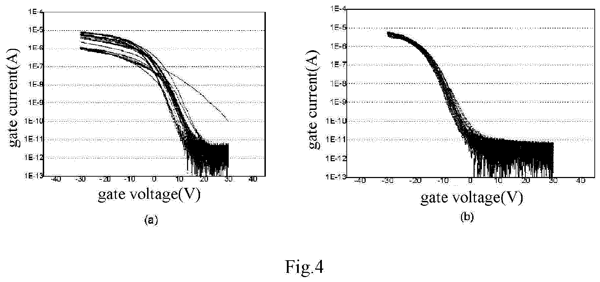

Fig. 4 shows a schematic comparison view for transfer characteristics of CNT-TFTs obtained without treatment by an acidic solution and with treatment by an acidic solution respectively. Specifically, Fig. 4(a) relates to transfer characteristic curves of 28 CNT-TFTs obtained when the CNT thin film layer has not been treated with an acidic solution, and Fig. 4(b) relates to transfer characteristic curves of 28 CNT-TFTs obtained when the CNT thin film layer has been treated with an acidic solution. As can be seen from Fig. 4(a), the transfer characteristic curves are spread out, which indicates that the transfer characteristics are not uniform between individual CNT-TFT devices. In contrast, as can be seen from Fig. 4(b), the transfer characteristic curves of 28 CNT-TFTs tend to be similar, which indicates that the transfer characteristic uniformity between each CNT-TFT device are distinctly improved.

It will be understood that the method of performing acidic solution treatment on the CNT thin film layer of CNT-TFT as shown in the embodiment of Fig. 1 and the reference embodiment not forming part of the present invention of Fig. 2 can be applied similarly to the manufacture of other types of CNT semiconductor devices, especially devices manufactured by a solution process. After treatment with an acidic solution, chemical impurities in the CNT layer for forming channels are removed, and in particular chemical substances on an outer wall of one or more carbon nanotubes for forming conductive channels are removed. This will effectively improve the performance uniformity of the semiconductor device.

## Claims

1. A manufacturing method of a carbon nanotube semiconductor device, comprising:
forming a carbon nanotube layer (350) with a carbon nanotube solution; and
treating the carbon nanotube layer with an acidic solution,
wherein the semiconductor device is a carbon nanotube field effect transistor or a carbon nanotube thin film transistor, and the carbon nanotube layer is at least partially used for forming a semiconductor layer between a source (330) and a drain (340) of the carbon nanotube field effect transistor or the carbon nanotube thin film transistor,
wherein the manufacturing method further comprises forming the source and the drain through a patterning process, before treating the carbon nanotube layer with an acidic solution,
wherein the step of forming the source and the drain through a patterning process comprises:
depositing a metal thin film layer;
forming a photoresist layer over the metal thin film layer through a patterning process, to cover the region in which the source and the drain are to be formed, and
performing etching by using the photoresist layer as a mask, until the carbon nanotube layer is exposed, with the photoresist layer being retained,
wherein the manufacturing method further comprises removing the photoresist layer after treatment of the carbon nanotube layer with the acidic solution.

2. The manufacturing method of a semiconductor device according to claim 1, further comprising:
prior to forming a carbon nanotube layer with a carbon nanotube solution, performing decentralized processing on the carbon nanotube solution with an organic solvent.

3. The manufacturing method of a semiconductor device according to claim 2, wherein the organic solvent is toluene, xylene, chloroform or o-xylene.

4. The manufacturing method of a semiconductor device according to claim 1, wherein the source and the drain are made of a metal material resistant to corrosion of acidic solutions.

5. The manufacturing method of a semiconductor device according to claim 1, wherein the carbon nanotube layer is treated with an acidic solution for 1 to 2 minutes.

6. The manufacturing method of a semiconductor device according to claim 1, wherein
carbon nanotubes in the carbon nanotube layer are single-wall carbon nanotubes, dual-wall carbon nanotubes, multi-wall carbon nanotubes, or a combination thereof; or
carbon nanotubes in the carbon nanotube layer are carbon nanotube bundles.

7. The manufacturing method of a semiconductor device according to claim 1, wherein the acidic solution is a mixed solution of phosphoric acid, nitric acid, and acetic acid.

8. The manufacturing method of a semiconductor device according to claim 7, wherein the phosphoric acid, the nitric acid, and the acetic acid in the mixed solution are respectively 73%∼85%, 3%∼7% and 3%∼7% by mass.

## Patentansprüche

1. Verfahren zur Herstellung einer Kohlenstoffnanoröhrchen-Halbleitervorrichtung, umfassend:
Bilden einer Kohlenstoffnanoröhrchenschicht (350) mit einer Kohlenstoffnanoröhrchenlösung; und
Behandeln der Kohlenstoffnanoröhrchenschicht mit einer sauren Lösung,
wobei die Halbleitervorrichtung ein Kohlenstoffnanoröhrchen-Feldeffekttransistor oder ein Kohlenstoffnanoröhrchen-Dünnschichttransistor ist und die Kohlenstoffnanoröhrchenschicht wenigstens teilweise zum Bilden einer Halbleiterschicht zwischen einer Source (330) und einem Drain (340) des Kohlenstoffnanoröhrchen-Feldeffekttransistors oder des Kohlenstoffnanoröhrchen-Dünnschichttransistors verwendet wird,
wobei das Herstellungsverfahren ferner Bilden der Source und des Drain durch ein Strukturierungsverfahren vor dem Behandeln der Kohlenstoffnanoröhrchenschicht mit einer sauren Lösung umfasst,
wobei der Schritt des Bildens der Source und des Drain durch ein Strukturierungsverfahren umfasst:
Abscheiden einer Metall-Dünnschicht;
Bilden einer Photoresistschicht über der Metall-Dünnschicht durch ein Strukturierungsverfahren, um den Bereich, in dem die Source und der Drain gebildet werden sollen, abzudecken, und
Durchführen von Ätzung unter Verwendung der Photoresistschicht als Maske, bis die Kohlenstoffnanoröhrchenschicht freigelegt ist, wobei die Photoresistschicht erhalten bleibt,
wobei das Herstellungsverfahren ferner Entfernen der Photoresistschicht nach der Behandlung der Kohlenstoffnanoröhrchenschicht mit der sauren Lösung umfasst.

2. Verfahren zur Herstellung einer Halbleitervorrichtung gemäß Anspruch 1, ferner umfassend:
vor dem Bilden einer Kohlenstoffnanoröhrchenschicht mit einer Kohlenstoffnanoröhrchenlösung Durchführen von dezentraler Verarbeitung der Kohlenstoffnanoröhrchenlösung mit einem organischen Lösungsmittel.

3. Verfahren zur Herstellung einer Halbleitervorrichtung gemäß Anspruch 2, wobei das organische Lösungsmittel Toluol, Xylol, Chloroform oder o-Xylol ist.

4. Verfahren zur Herstellung einer Halbleitervorrichtung gemäß Anspruch 1, wobei die Source und der Drain aus einem Metallmaterial bestehen, das gegen Korrosion durch saure Lösungen beständig ist.

5. Verfahren zur Herstellung einer Halbleitervorrichtung gemäß Anspruch 1, wobei die Kohlenstoffnanoröhrchenschicht für 1 bis 2 Minuten mit einer sauren Lösung behandelt wird.

6. Verfahren zur Herstellung einer Halbleitervorrichtung gemäß Anspruch 1, wobei
Kohlenstoffnanoröhrchen in der Kohlenstoffnanoröhrchenschicht einwandige Kohlenstoffnanoröhrchen, doppelwandige Kohlenstoffnanoröhrchen, mehrwandige Kohlenstoffnanoröhrchen oder eine Kombination davon sind; oder
Kohlenstoffnanoröhrchen in der Kohlenstoffnanoröhrchenschicht Kohlenstoffnanoröhrchenbündel sind.

7. Verfahren zur Herstellung einer Halbleitervorrichtung gemäß Anspruch 1, wobei die saure Lösung eine gemischte Lösung von Phosphorsäure, Salpetersäure und Essigsäure ist.

8. Verfahren zur Herstellung einer Halbleitervorrichtung gemäß Anspruch 7, wobei die Phosphorsäure, die Salpetersäure und die Essigsäure in der gemischten Lösung 75 Masse-% bis 85 Masse-%, 3 Masse-% bis 7 Masse-% bzw. 3 Masse-% bis 7 Masse-% darstellen.

## Revendications

1. Procédé de fabrication d'un dispositif semi-conducteur à nanotubes de carbone, comprenant :
la formation d'une couche de nanotubes de carbone (350) avec une solution de nanotubes de carbone ; et
le traitement de la couche de nanotubes de carbone avec une solution acide,
le dispositif semi-conducteur étant un transistor à effet de champ à nanotubes de carbone ou un transistor en film mince à nanotubes de carbone, et la couche de nanotubes de carbone étant au moins partiellement utilisée pour la formation d'une couche semi-conductrice entre une source (330) et un drain (340) du transistor à effet de champ à nanotubes de carbone ou du transistor en film mince à nanotubes de carbone,
le procédé de fabrication comprenant en outre la formation de la source et du drain par l'intermédiaire d'un processus de formation de motif, avant le traitement de la couche de nanotubes de carbone avec une solution acide,
l'étape de formation de la source et du drain par l'intermédiaire d'un processus de formation de motif comprenant :
le dépôt d'une couche en film mince de métal ;
la formation d'une couche de photorésine sur la couche en film mince de métal par l'intermédiaire d'un processus de formation de motif, pour couvrir la zone dans laquelle la source et le drain doivent être formés, et
la réalisation d'une gravure en utilisant la couche de photorésine comme un masque, jusqu'à ce que la couche de nanotubes de carbone soit exposée, la couche de photorésine étant conservée,
le procédé de fabrication comprenant en outre l'élimination de la couche de photorésine après le traitement de la couche de nanotubes de carbone avec la solution acide.

2. Procédé de fabrication d'un dispositif semi-conducteur selon la revendication 1, comprenant en outre :
avant la formation d'une couche de nanotubes de carbone avec une solution de nanotubes de carbone, la réalisation d'un traitement décentralisé sur la solution de nanotubes de carbone avec un solvant organique.

3. Procédé de fabrication d'un dispositif semi-conducteur selon la revendication 2, le solvant organique étant le toluène, le xylène, le chloroforme ou l'o-xylène.

4. Procédé de fabrication d'un dispositif semi-conducteur selon la revendication 1, la source et le drain étant faits d'un matériau métallique résistant à la corrosion de solutions acides.

5. Procédé de fabrication d'un dispositif semi-conducteur selon la revendication 1, la couche de nanotubes de carbone étant traitée avec une solution acide pendant 1 à 2 minutes.

6. Procédé de fabrication d'un dispositif semi-conducteur selon la revendication 1,
les nanotubes de carbone dans la couche de nanotubes de carbone étant des nanotubes de carbone mono-paroi, des nanotubes de carbone à double paroi, des nanotubes de carbone à plusieurs parois, ou une combinaison correspondante ; ou
les nanotubes de carbone dans la couche de nanotubes de carbone étant des paquets de nanotubes de carbone.

7. Procédé de fabrication d'un dispositif semi-conducteur selon la revendication 1, la solution acide étant une solution mixte d'acide phosphorique, d'acide nitrique, et d'acide acétique.

8. Procédé de fabrication d'un dispositif semi-conducteur selon la revendication 7, l'acide phosphorique, l'acide nitrique, et l'acide acétique dans la solution mixte étant respectivement de 75 % à 85 %, 3 % à 7 % et 3 % à 7 % en masse.
